# EUROPÄISCHE PATENTSCHRIFT

(11) **EP 0 555 526 B1**
(45) Veröffentlichungstag und Bekanntmachung des Hinweises auf die Patenterteilung: **08.04.1998**
(21) Anmeldenummer: 92117960.2
(22) Anmeldetag: 21.10.1992
(51) Int. Cl.: G01R 27/26, G01F 23/26

(54) **Anordnung zur potentialgetrennten Kapazitätsmessung, insb. zur kapazitiven Füllstandmessung**
Assembly for floating potential capacitance measurement, in particular for capacitive filling level measurement
Assemblage pour la mesure de capacité à potentiel flottant, en particulier pour la mesure capacitive de niveau de liquide

(30) Priorität: 08.02.1992 DE 4203725
(43) Veröffentlichungstag der Anmeldung: 18.08.1993
(73) Patentinhaber: VEGA Grieshaber KG, 77709 Wolfach (DE)
(72) Erfinder: Raffalt, Felix, Dipl.-Ing., W-7612 Fischerbach (DE)
(74) Vertreter: Patentanwälte Westphal, Buchner, Mussgnug Neunert, Göhring

(56) Entgegenhaltungen:
- DE-A- 2 819 731
- GB-A- 1 486 416
- JEE JOURNAL OF ELECTRONIC ENGINEERING Nr. 76, März 1973, TOKYO JP Seite 84,ELECTROTECHNICAL LAB.:'Accuracy of 0,1% obtained in precision capacity measurement'
- DATABASE WPI Section EI, Week 8023, 16. Juli 1980 Derwent Publications Ltd., London, GB; Class S01, Page 14, AN 80-F0738C & SU-A-691 778

## Beschreibung

Die Erfindung betrifft eine Anordnung zur potentialgetrennten Kapazitätsmessung, insbesondere zur kapazitiven Füllstandmessung, mit einem Wechselspannungsgenerator, der die zu messende Kapazität über einen induktiven Übertrager speist, und einer Auswerteschaltung, die den Kapazitätswert in ein Ausgangssignal umsetzt.

Generell sind kapazitive Füllstandssonden, bei denen das zu messende Füllgut einen Teil des Meßstromkreises bildet, aufgrund ihres Funktionsprinzips an das Füllgut potentialmäßig gebunden, so daß man in der Regel auf eine galvanische Trennung in der Auswerteschaltung angewiesen ist. Diese Trennung kann aus Gründen einer sicheren Isolierung gegenüber dem Versorgungsnetz, des Ex-Schutzes, der Vermeidung von Erdschleifen und/oder der Verhinderung von Hochfrequenz-Ausgleichsströmen zwischen dem Füllgutbehälter und der Umgebung erforderlich sein.

In der Praxis wird die Potentialtrennung üblicherweise durch Einsatz eines Netztransformators oder Gleichstromwandlers bei der Versorgungsspannung und eines Optokopplers oder einer Trennübertragerstufe für den Meßwertausgang durchgeführt. Allerdings kann der hierfür benötigte Teileaufwand, insbesondere wenn die Gewinnung eines streng linearen Analogmeßwertes angestrebt ist, verhältnismäßig hoch sein.

Eine dem Oberbegriff des Patentanspruchs 1 entsprechende Anordnung zur potentialgetrennten Kapazitätsmessung ist aus der DE 28 19 731 A1 bekannt. Bei der bekannten Anordnung ist der Hochfrequenzgenerator über einen Übertrager mit den Meßelektroden verbunden, wobei das Meßausgangssignal über einen Meßwandler in ein füllstandsabhängiges Gleichspannungssignal umgesetzt wird. Über den Aufbau des Meßwandlers sind dieser Druckschrift keine näheren Angaben entnehmbar. Wie bereits ausgeführt, kann insbesondere dann, wenn einerseits eine Potentialtrennung und andererseits die Gewinnung eines hochlinearen Analogmeßwerts gewünscht sind, der benötigte Schaltungsaufwand relativ hoch werden.

Aus GB-A-1 486 416 ist ebenfalls eine Anordnung zur potentialgetrennten Kapazitätsmessung bekannt. Die Schaltung bedart jedoch zwingend einer Kompensationskapazität.

Aus dem Dokument JEE JOURNAL, March 1973, Seite 84, ist ebenfalls eine Schaltungsanordnung zur potentialgetrennten Kapazitätsmessung bekannt. Die Schaltung braucht eine Hilfsspannungsquelle, die der Polarisation eines zu messenden Elektrolytkondensators dient. Darüber hinaus ist auch eine Kompensationskapazität erforderlich.

Der Erfindung liegt die Aufgabe zugrunde, eine Anordnung zur potentialgetrennten Kapazitätsmessung zu schaffen, die eine Potentialtrennung bei verhältnismäßig einfachem Aufbau unter Erzielung eines zuverlässigen, aussagekräftigen Meßwert-Ausgangssignals ermöglicht.

Diese Aufgabe wird mit den im Patentanspruch 1 genannten Merkmalen gelöst.

Vorteilhafte Ausgestaltungen der Erfindung sind in den Unteransprüchen angegeben.

Durch die erfindungsgemäße Ausgestaltung der Anordnung läßt sich die Anzahl der für die Potentialtrennung benötigten Bauteile auf ein Minimum reduzieren, wodurch sich eine erhebliche Einsparung an Kosten, Bauvolumen und Gewicht bei gleichzeitig erhöhter Zuverlässigkeit ergibt. Dies wird dadurch ermöglicht, daß die Potentialtrennung bereits während der Kapazitätsmessung durchgeführt wird und folglich eine eigene Trennung für die Versorgungsspannung und den Meßwert entfallen kann. Die zu messende Kapazität ist hierbei einerseits über einen Spannungswandler mit dem Wechselspannungsgenerator und andererseits über einen Stromwandler mit der Auswerteschaltung gekoppelt. Hierdurch wird eine vollständige Potentialtrennung zwischen Meßsonde und Auswerteelektronik erreicht. Durch die Verwendung eines mit stabilisierter Spannung gespeisten Spannungswandlers ist die an die zu messende Kapazität angelegte Spannung stets unabhängig von der Amplitude des gerade über die Kapazität fließenden Stroms.

Ebenso bewirkt der ausgangsseitig vorgesehene reine Stromwandler eine potentialgetrennte, unverfälschte Übertragung des durch die Kapazität fließenden Stroms zur Auswerteschaltung ohne irgendwelche eigenen Auswirkungen auf die Spannungsverhältnisse an der zu messenden Kapazität, so daß eine unverfälschte, exakte, potentialgetrennte Erfassung und Auswertung des aktuellen Kapazitätswerts durch die Auswerteschaltung möglich ist. Bei der erfindungsgemäßen Anordnung gehen somit weder Schwankungen der Eigeninduktivität noch der Eigenkapazität der beiden induktiven Übertrager in die Messung ein. Die Meßgenauigkeit ist somit temperaturunabhängig, obwohl die Eigeninduktivität und die Eigenkapazität der beiden Übertrager in der Praxis aufgrund deren Temperaturabhängigkeit nicht als konstant angesehen werden können.

Gemäß der Erfindung ist die Sekundärseite des zweiten induktiven Übertragers mit einer Kompensationsstromtreiberschaltung mit virtuellem Eingangswiderstand von annähernd 0 Ohm abgeschlossen. Damit kann über dem zweiten induktiven Übertrager selbst keine Spannung anstehen, so daß gewährleistet ist, daß der zweite Übertrager als reiner Stromwandler arbeitet. Somit ergeben sich weder vom zweiten induktiven Übertrager noch vom ersten induktiven Übertrager spannungsmäßige Rückwirkungen auf die zu messende Kapazität. Dadurch wird die Meßgenauigkeit erhöht. Durch den Einsatz der Kompensationsstromtrieberschaltung wird die Spannungsfreiheit des zweiten Übertragers und somit dessen reine Stromwandlereigenschaft gewährleistet. Die in der Kompensationsstromtreiberschaltung fließenden Ströme sind folglich der zu messenden Kapazität proportional.

Durch Einsatz einer Tiefpaßschaltung können die in der Kompensationsstromtreiberschaltung fließenden Ströme in ein von hochfrequenten Wechselspannungskomponenten befreites Gleichspannungssignal, dessen Größe dem gemessenen Kapazitätswert entspricht, umgesetzt werden. Hierdurch kann eine hohe Linearität des Ausgangssignals erzielt werden.

Um zu gewährleisten, daß der erste induktive Übertrager als reiner Spannungswandler arbeitet, wird vorzugsweise ein Wechselspannungsgenerator mit einem Innenwiderstand von im wesentlichen oder exakt 0 Ohm eingesetzt, so daß auf sonstige Kompensationsmaßnahmen verzichtet werden kann. Hierdurch verringert sich auch der schaltungstechnische Aufwand. Der erste induktive Übertrager gibt somit eine von der aktuellen Belastung unabhängige Spannung an die zu messende Kapazität ab, wodurch an der zu messenden Kapazität stets konstante Effektivspannung anliegt.

In bevorzugter Ausgestaltung sind die zu messende Kapazität und die Primärwicklung des zweiten Übertragers als Serienschaltung geschaltet, die parallel zur Sekundärwicklung des ersten Übertragers liegt. Hierdurch wird sichergestellt, daß der gesamte Kapazitätsstrom auch die Primärseite des zweiten Übertragers durchfließt, so daß sekundärseitig des zweiten Übertragers ein dem durch die Kapazität fließenden Strom direkt proportionaler Strom abgreifbar ist. Diese Serienschaltung zeichnet sich durch besondere schaltungstechnische Einfachheit und Zuverlässigkeit aus.

Wenn keiner der Primäranschlüsse des zweiten induktiven Übertragers sowie der Sekundäranschlüsse des ersten Übertragers geerdet ist, lassen sich sogar symmetrische erdfreie Füllstandssonden oder sonstige erdfreie Kapazitäten exakt und störungsfrei auswerten. Solche Füllstandssonden sind beispielsweise Zweistabelektroden. Durch die potentialgetrennte symmetrische Ansteuerung solcher Sonden können keine hochfrequenten Ausgleichsströme zwischen dem Füllgut und der Umgebungserde fließen, so daß die Erdungsverhältnisse des Behälters nicht in das Meßergebnis eingehen. Dies ist von besonderer Wichtigkeit, da derartige Sonden in der Regel in Behältern eingesetzt werden, welche nicht metallisch sind. Variable Einflüsse wie etwa die Umgebungsfeuchte oder sich dem Behälter nähernde Personen oder Fahrzeuge könnten nämlich bei Vorhandensein von Ausgleichsströmen Meßfehler von über 30 % verursachen. Mit der erfindungsgemäßen Anordnung ist dagegen allenfalls die in der Regel vernachlässigbare Koppelkapazität der Übertrager zu Erde hin wirksam, so daß eine sehr präzise Messung auch solcher Sonden ermöglicht ist.

Es ist aber auch möglich, einen der Primärwicklungsanschlüsse des zweiten Übertragers auf Massepotential zu legen, insbesondere durch direkte Verbindung eines Anschlusses der zu messendan Kapazität mit Erde. In diesem Fall besitzt auch der nicht geerdete primärseitige Wicklungsanschluß des zweiten Übertragers ein mit Erde identisches Potential, da der zweite Übertrager als Stromwandler ohne Spannungsabfall arbeitet. Somit sind die Potentialverhältnisse der Primärwicklung des zweiten Übertragers und des einen Kapazitätsanschlusses stets definiert. Die Verbindung zwischen dem nicht geerdeten primärseitigen Wicklungsanschluß des zweiten Übertragers und dem einen Anschluß der Sekundärwicklung des ersten Übertragers kann dabei als potentialgetrennter Schirmanschluß mit Erdpotential eingesetzt werden, der es erlaubt, unerwünschte hochfrequente Ströme nach Erde abzuleiten, ohne sie in die Messung eingehen zu lassen. Anwendungen hierfür sind der Anschluß von Triaxialkabeln zur Sondenfernspeisung und die Ansteuerung von Sonden mit Schirmsegment zur Füllgutansatzkompensation, wie sie aus der DE 38 43 339 A1 und der DE 28 19 731 C2 bekannt sind. Die Funktion des Schirmes bleibt auch bei erdfreien Anwendungen voll erhalten.

Von Vorteil ist weiterhin, dem zweiten Übertrager eine weitere Primärwicklung hinzuzufügen, die einen um 180° phasenverschobenen Eingang bildet. An diese weitere Primärwicklung kann eine zur Auswerteschaltung gleichfalls potentialgetrennte Kompensationskapazität angeschlossen werden, wobei die Serienschaltung aus Kompensationskapazität und weiterer Primärwicklung parallel zu den Sekundärwicklungsanschlüssen des ersten Übertragers liegen kann. Die Kompensationskapazität wirkt dem von der zu messenden Kapazität erzeugten Sondenstrom entgegen und ist damit in der Lage, einen eventuell unerwünschten, sich aus einer Sondengrundkapazität ergebenden Meß-Offset zu kompensieren.

Die Kompensationskapazität ist zwischen den einen Anschluß der zu messenden Kapazität und die weitere Primärwicklung des zweiten Übertragers geschaltet. Die 180°-Phasenverschiebung des Kompensationsstroms der Kompensationskapazität findet somit nicht - wie bei bekannten Schaltungen - im ersten Übertrager, sondern im zweiten Übertrager statt. Dies ermöglicht z. B. eine Bereichsumschaltung des Abgriffs der Sekundärwicklung des ersten Übertragers, wobei die Kompensationskapazität in gleicher Weise wie die zu messende Kapazität bereichsumgeschaltet wird, so daß die Kompensationswirkung der Kompensationskapazität unabhängig vom jeweils eingestellten Meßbereich ist.

Die direkte Verbindung von Anschlüssen der beiden Primärwicklungen des zweiten Übertragers erlaubt eine definierte gegenseitige potentialmäßige Festlegung der Primärwicklungen und bringt zudem in wicklungs- und schaltungstechnischer Hinsicht verringerten Aufwand.

Zur vereinfachten Bereichsumschaltung ist die Sekundärwicklung des ersten Übertragers vorzugsweise mit mehreren Abgriffen ausgestattet, mit denen ein Anschluß der zu messenden Kapazität selektiv über einen Schalter verbindbar ist. Damit ist die an die zu messende Kapazität anzulegende konstante Spannungamplitude variabel und kann folglich in einfacher Weise an die jeweiligen Kapazitätsverhältnisse angepaßt werden.

Die erfindungsgemäße Anordnung eignet sich nicht nur zur Füllstandsmessung, sondern ist allgemein zur Messung unbekannter oder sich verändernder Kapazitäten bzw. Admitanzen geeignet.

Die Meß- und Kompensationskapazität können Bestandteil eines Differenzkondensators sein. Ferner kann die Kompensationskapazität auch zwischen zwei Wicklungen des ersten und zweiten Übertragers geschaltet werden, die zu den übrigen Wicklungen keine galvanische Verbindung besitzen, so daß die Messung der Kompensationskapazität sowohl in bezug auf die Auswerteelektronik wie auch auf die Meßkapazität potentialgetrennt erfolgt.

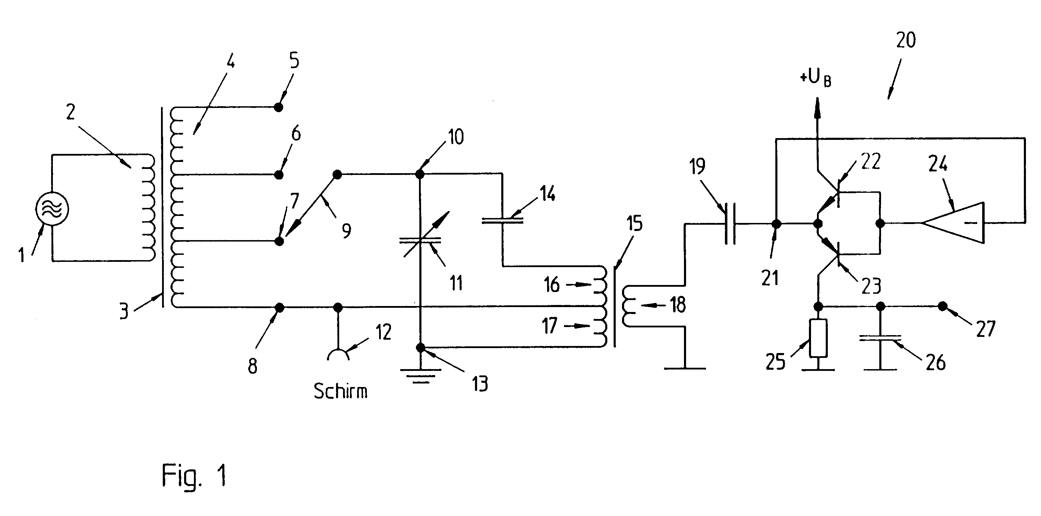

Die Erfindung wird nachstehend anhand eines in der Zeichnung gezeigten Ausführungsbeispiels der erfindungsgemäßen Anordnung zur potentialgetrennten Kapazitätsmessung näher beschrieben.

Bei dem in der Zeichnung gezeigten Ausführungsbeispiel der erfindungsgemäßen Anordnung ist ein Wechselspannungsgenerator in Form eines Hochfrequenz-Generators 1 vorhanden, der mit der Primärwicklung 2 eines ersten induktiven Übertragers 3 verbunden ist. Der Übertrager 3 weist eine Sekundärwicklung 4 mit drei Abgriffen 5, 6 und 7 sowie einem endseitigen Anschluß 8 auf. Ein Anschluß 10 einer zu messenden Kapazität 11, beispielsweise einer Füllstandssonde, ist über einen Schalter 9 wahlweise mit einem der Anschlüsse 5, 6 oder 7 verbunden, an denen jeweils unterschiedliche Spannungen auftreten. Da der Wechselspannungsgenerator 1 einen Innenwiderstand von 0 Ohm aufweist, arbeitet der induktive Übertrager 3 als reiner Spannungswandler, so daß die an den Anschlüssen 5, 6 und 7 jeweils auftretende Effektivspannung unabhängig vom jeweils fließenden Sekundärwicklungsstrom konstant ist. Die zu messende Kapazität 11 wird somit mit konstanter Spannung beaufschlagt.

Der andere Anschluß 13 der zu messenden Kapazität 11 ist mit einem Anschluß einer Primärwicklung 17 eines zweiten induktiven Übertragers 15 verbunden, wobei der andere Anschluß der Primärwicklung 17 mit dem Anschluß 8 der Sekundärwicklung 4 des ersten induktiven Übertragers 3 verbunden ist. Der Anschluß 13 ist direkt mit Erde verbunden, das heißt liegt auf Massepotential. Der zweite Übertrager 15 arbeitet als reiner Stromwandler und weist eine zweite Primärwicklung 16 auf, die mit einem Anschluß direkt mit dem mit dem Anschluß 8 verbundenen Anschluß der ersten Primärwicklung 17 verbunden und mit ihrem anderen Anschluß an eine Kompensationskapazität 14 angeschlossen ist. Der andere Anschluß der Kompensationskapazität 14 ist mit dem Anschluß 10 verschaltet.

Da der zweite induktive Übertrager 15 als Stromwandler arbeitet, besitzt auch der nicht geerdete andere Anschluß der Primärwicklung 17 ein mit Massepotential identisches Potential, so daß er bzw. die mit ihm verbundene Leitung als potentialgetrennter Schirmanschluß 12 dienen kann, über den unerwünschte hochfrequente Ströme nach Masse abgeleitet werden können. Der Schirmanschluß 12 kann beispielsweise für den Anschluß von Triaxialkabeln oder die Ansteuerung von Sonden mit Schirmsegment herangezogen werden.

Der zweite induktive Übertrager 15 besitzt eine Sekundärwicklung 18, die einseitig auf Nullpotential liegt und mit ihrem anderen Anschluß über einen Abblockkondensator 19 an eine Kompensationsstromtreiberschaltung 20 angeschlossen ist. Die Kompensationsstromtreiberschaltung 20 gewährleistet, daß über den zweiten induktiven Übertrager 15 keine Spannung ansteht und dieser somit als reiner Stromwandler arbeiten kann.

Die Kompensationsstromtreiberschaltung 20 dient als Strom-Spannungswandler und zugleich als Gleichrichtschaltung und umfaßt einen invertierenden Hochfrequenz-Verstärker 24, dessen Eingang mit einem Anschluß 21 und dessen Ausgang mit den Basen zweier emittergekoppelter Transistoren 22, 23 unterschiedlichen Leitungstyps verbunden ist. Der Anschluß 21 entspricht der nicht mit der Sekundärwicklung 18 verbundenen Anschlußelektrode des Abblockkondensators 19.

Der Verbindungspunkt zwischen den Emittern der Transistoren 22, 23 ist gleichfalls mit dem Anschluß 21 verbunden, während der Kollektor des Transistors 22 mit der Versorgungsspannung und der Kollektor des Transistors 23 mit einer Tiefpaßschaltung verbunden ist, die aus einer Parallelschaltung eines Widerstands 25 und einer Kapazität 26 besteht. Der Verbindungspunkt zwischen dem Transistor 23 und der Tiefpaßschaltung dient als Ausgangsanschluß 27, an dem eine dem gemessenen Wert der Kapazität 11 entsprechende Gleichspannung abgegriffen wird. Die an den Endstufen-Transistoren 22, 23 auftretenden Kollektorströme sind dabei der zu messenden Kapazität 11 proportional. Die Transistoren 22, 23 leiten abwechselnd jeweils eine Halbwelle des Meßwechselstromes. Auf diese Weise wird der Eingangswechselstrom der Kompensationsstromtreiberschaltung 20 in zwei pulsierende Gleichströme aufgespaltet, welche in den Kollektorleitungen der beiden Transistoren 22, 23 fließen. Beide Ströme sind zueinander um 180° phasenverschoben, besitzen aber den gleichen arithmetischen Mittelwert. Der Kollektorstrom von Transistor 23 wird durch die Tiefpaßschaltung 25, 26 in eine entsprechende Gleichspannung umgesetzt.

Die Arbeitsweise der erfindungsgemäßen Anordnung ist wie folgt:
Der Wechselspannungsgenerator 1 speist über den induktiven Übertrager 3 und den über den Schalter 9 umschaltbaren Abgriff die einseitig auf Massepotential liegende, zu messende Kapazität 11 mit Wechselspannung. Der daraus resultierende kapazitätsproportionale Strom fließt von Erde über die Primärwicklung 17 des zweiten induktiven Übertragers 15 zum Anschluß 8 des ersten Übertragers 3 zurück. Der primärseitig im zweiten induktiven Übertrager 15 fließende Strom wird über dessen Stromwandlerfunktion zu entsprechenden Kollektorströmen der Transistoren 22, 23 der Kompensationsstromtreiberschaltung 20 umgesetzt, die wiederum über die Tiefpaßschaltung 25, 26 in das Gleichspannungs-Ausgangssignal umgewandelt werden.

Die weitere Primärwicklung 16 des zweiten induktiven Übertragers 15 bildet einen um 180° phasenverschobenen Eingang und ist an die Kompensationskapazität 14 angeschlossen, die somit ebenso wie die zu messende Kapazität 11 gegenüber der Auswerteschaltung potentialgetrennt ist. Die Kompensationskapazität 14 wirkt dem von der zu messenden Kapazität 11 erzeugten Sondenstrom entgegen und kompensiert damit einen aus einer Sondengrundkapazität resultierenden Meß-Offset.

Durch den variablen Abgriff der Sekundärspannung des ersten induktiven Übertragers 3 lassen sich verschiedene Meßbereiche für die Kapazitätsmeßschaltung einstellen. Da die 180°-Phasenverschiebung des Kompensationsstromes der Kompensationskapazität 14 im zweiten induktiven Übertrager 15 wirksam ist, wird die Kompensationskapazität 14 in gleicher Weise wie die zu messende Kapazität 11 durch Umschaltung des Schalters 9 bereichsumgeschaltet und ist folglich in ihrer Wirkung unabhängig von dem gerade eingestellten Meßbereich.

## Patentansprüche

1. Anordnung zur potentialgetrennten Kapazitätsmessung, insbesondere zur kapazitiven Füllstandmessung, mit einem Wechselspannungsgenerator (1), der die zu messende Kapazität (11) über einen ersten induktiven Übertrager (3) speist, und einer Auswerteschaltung (19 bis 27), die den gemessenen Wert der Kapazität in ein Ausgangssignal umsetzt, dadurch gekennzeichnet, daß der erste induktive Übertrager (3) als Spannungswandler ausgelegt ist, bei dem die an den Ausgangsanschlüssen (5, 6, 7) jeweils auftretende Effektivspannung unabhängig vom jeweils fließenden Sekundärwicklungsstrom konstant ist, und daß die zu messende Kapazität (11) mit der Primärseite (16, 17) eines zweiten induktiven Übertragers (15) verbunden ist, der als Stromwandler arbeitet und dessen Sekundärseite (18) mit einer Kompensationsstromtreiberschaltung (20) mit virtuellem Eingangswiderstand von annähernd 0 Ohm in der Auswerteschaltung (19 bis 27) verschaltet ist.

2. Anordnung nach Anspruch 1, dadurch gekennzeichnet, daß die Kompensationsstromtreiberschaltung (20) mit einer Tiefpaßschaltung (25, 26) verbunden ist, an deren Ausgang (27) das Ausgangssignal der Auswerteschaltung abgreifbar ist.

3. Anordnung nach Anspruch 1 oder 2, dadurch gekennzeichnet, daß der Wechselspannungsgenerator (1) einen Innenwiderstand von im wesentlichen 0 Ohm besitzt.

4. Anordnung nach einem der vorhergehenden Ansprüche, dadurch gekennzeichnet, daß ein Anschluß einer Sekundärwicklung (4) des ersten induktiven Übertragers (3) direkt mit einem Anschluß (10) der zu messenden Kapazität (11) und ein weiterer Anschluß (8) der Sekundärwicklung (4) des ersten induktiven Übertragers (3) mit einem Anschluß einer Primärwicklung (17) des zweiten induktiven Übertragers (15) verbunden ist, während ein weiterer Anschluß der Primärwicklung (17) des zweiten induktiven Übertragers (15) mit dem anderen Anschluß (13) der zu messenden Kapazität (11) verbunden ist.

5. Anordnung nach Anspruch 4, dadurch gekennzeichnet, daß keiner der Anschlüsse (8, 13) der Primärwicklung (17) des zweiten induktiven Übertragers (15) geerdet ist.

6. Anordnung nach Anspruch 4 oder 5, dadurch gekennzeichnet, daß ein Anschluß der Primärwicklung (17) des zweiten induktiven Übertragers (15), vorzugsweise der mit der zu messenden Kapazität (11) verbundene Anschluß (13), auf Massepotential liegt.

7. Anordnung nach Anspruch 4-6, dadurch gekennzeichnet, daß die Verbindungsleitung zwischen einem Anschluß (8) der Sekundärwicklung (4) des ersten induktiven Übertragers (3) und einem Anschluß der Primärwicklung (17) des zweiten induktiven Übertragers (15) mit einem Schirmanschluß (12) versehen ist.

8. Anordnung nach Anspruch 4, dadurch gekennzeichnet, daß der zweite induktive Übertrager (15) eine weitere Primärwicklung (16) aufweist, die zusammen mit einer Kompensationskapazität (14) eine parallel zu den Sekundärwicklungsanschlüssen des ersten induktiven Übertragers (3) liegende Reihenschaltung bildet.

9. Anordnung nach Anspruch 8, dadurch gekennzeichnet, daß die Kompensationskapazität (14) zwischen die weitere Primärwicklung (16) und den einen Anschluß der zu messenden Kapazität (11) geschaltet ist.

10. Anordnung nach Anspruch 8 oder 9, dadurch gekennzeichnet, daß die beiden Primärwicklungen (16, 17) des zweiten induktiven Übertragers (15) an einem Anschluß direkt miteinander verbunden sind.

11. Anordnung nach einem der vorhergehenden Ansprüche, dadurch gekennzeichnet, daß die Sekundärwicklung (4) des ersten induktiven Übertragers (3) mehrere Abgriffe (5, 6, 7) aufweist, mit denen ein Anschluß (10) der zu messenden Kapazität (11) selektiv über einen Schalter (9) verbindbar ist.

## Claims

1. Device for the floating measurement of capacitance, in particular for the capacitive measurement of level, comprising an alternating-voltage generator (1) which supplies the capacitance (11) to be measured via a first inductive transformer (3), and comprising an evaluation circuit (19 to 27) which converts the measured value of the capacitance into an output signal, characterized in that the first inductive transformer (3) is designed as voltage converter for which the respective rms voltage appearing at the output connections (5, 6, 7) is constant regardless of the respective secondary-winding current flowing and in that the capacitance (11) to be measured is connected to the primary side (16, 17) of a second inductive transformer (15) which functions as current converter and whose secondary side (18) is connected to a compensation-current driver circuit (20) having virtual input resistance of approximately 0 ohm in the evaluation circuit (19 to 27).

2. Device according to Claim 1, characterized in that the compensation-current driver circuit (20) is connected to a low-pass circuit (25, 26) at whose output (27) the output signal of the evaluation circuit can be tapped off.

3. Device according to Claim 1 or 2, characterized in that the alternating-voltage generator (1) has an internal resistance of essentially 0 ohm.

4. Device according to one of the preceding claims, characterized in that a connection of a secondary winding (4) of the first inductive transformer (3) is connected directly to a connection (10) of the capacitance (11) to be measured and a further connection (8) of the secondary winding (4) of the first inductive transformer (3) is connected to a connection of a primary winding (17) of the second inductive transformer (15), while a further connection of the primary winding (17) of the second inductive transformer (15) is connected to the other connection (13) of the capacitance (11) to be measured.

5. Device according to Claim 4, characterized in that none of the connections (8, 13) of the primary winding (17) of the second inductive transformer (15) is earthed.

6. Device according to Claim 4 or 5, characterized in that a connection of the primary winding (17) of the second inductive transformer (15), preferably the connection (13) connected to the capacitance (11) to be measured, is at earth potential.

7. Device according to Claims 4 - 6, characterized in that the connecting line between a connection (8) of the secondary winding (4) of the first inductive transformer (3) and a connection of the primary winding (17) of the second inductive transformer (15) is provided with a shield connection (12).

8. Device according to Claim 4, characterized in that the second inductive transformer (15) has a further primary winding (16) which forms, together with a compensation capacitance (14), a series connection situated in parallel with the secondary-winding connections of the first inductive transformer (3).

9. Device according to Claim 8, characterized in that the compensation capacitance (14) is connected between the further primary winding (16) and the one connection of the capacitance (11) to be measured.

10. Device according to Claim 8 or 9, characterized in that the two primary windings (16, 17) of the second inductive transformer (15) are directly connected to each other at one connection.

11. Device according to one of the preceding claims, characterized in that the secondary winding (4) of the first inductive transformer (3) has a plurality of tappings (5, 6, 7) to which one connection (10) of the capacitance (11) to be measured can be selectively connected via a switch (9).

## Revendications

1. Assemblage pour la mesure de la capacité à potentiel flottant, en particulier pour la mesure capacitive de niveau, comportant un générateur de tension alternative (1), qui alimente la capacité (11) à mesurer par l'intermédiaire d'un premier transformateur inductif (3) et un circuit d'exploitation (19 à 27), qui transforme la valeur mesurée de la capacité en un signal de sortie,
caractérisé en ce que
• le premier transformateur inductif (3) est dimensionné en transformateur de tension, dans lequel la tension effective résultant respectivement aux bornes de sortie (5, 6, 7) est constante indépendamment du courant de l'enroulement secondaire circulant respectivement, et
• la capacité à mesurer (11) est reliée au côté primaire (16, 17) d'un deuxième transformateur inductif (15), qui opère en transformateur d'intensité et dont le côté secondaire (18) est relié à un circuit d'excitation de courant de compensation (20) avec une résistance d'entrée virtuelle d'approximativement 0 ohm dans le montage d'évaluation (19 à 27).

2. Assemblage selon la revendication 1,
caractérisé en ce que
le circuit d'excitation de courant de compensation (20) est lié à un montage passe-bas (25, 26), à la sortie duquel on peut saisir le signal de sortie du circuit d'exploitation.

3. Assemblage selon les revendications 1 ou 2,
caractérisé en ce que
le générateur de tension alternative (1) possède une résistance interne essentiellement de 0 ohm.

4. Assemblage selon une des revendications précédentes,
caractérisé en ce qu'
une borne d'un enroulement secondaire (4) du premier transformateur inductif (3) est relié directement à une borne (10) de la capacité (11) à mesurer et une autre borne (8) de l'enroulement secondaire (4) du premier transformateur inductifs (3) est reliée à un raccordement d'un enroulement primaire (17) du deuxième transformateur inductif (15), tandis qu'un autre raccordement de l'enroulement primaire (17) du deuxième transformateur inductif (15) est relié à l'autre borne (13) de la capacité (11) à mesurer.

5. Assemblage selon la revendication 4,
caractérisé en ce qu'
aucune des bornes (8, 13) de l'enroulement primaire (17) du deuxième transformateur inductif (15) est mise à la terre.

6. Assemblage selon les revendications 4 ou 5,
caractérisé en ce qu'
une borne de l'enroulement primaire (17) du deuxième transformateur inductif (15), de préférence la borne (13) reliée à la capacité à mesurer (11) est mise au potentiel de la masse.

7. Assemblage selon les revendications 4 à 6,
caractérisé en ce que
la ligne électrique de liaison entre une borne (8) de l'enroulement secondaire (4) du premier transformateur inductif (3) et une borne de l'enroulement primaire (17) du deuxième transformateur inductif (15) est munie d'une borne à écran (12).

8. Assemblage selon la revendication 4,
caractérisé en ce que
le deuxième transformateur inductif (15) comporte un autre enroulement primaire (16), qui forme en commun avec une capacité de compensation (14) un montage en série situé en parallèle par rapport aux raccordements d'enroulement secondaire du premier transformateur inductif (3).

9. Assemblage selon la revendication 8,
caractérisé en ce que
la capacité de compensation (14) est montée entre l'autre enroulement primaire (16) et l'une des bornes de capacité (11) à mesurer.

10. Assemblage selon les revendications 8 ou 5,
caractérisé en ce que
les deux enroulements primaires (16, 17) du deuxième transformateur inductif (15) sont reliés ensemble directement sur une borne.

11. Assemblage selon une des revendications précédentes,
caractérisé en ce que
l'enroulement secondaire (4) du premier transformateur inductif (3) comporte plusieurs prises (5, 6, 7), avec lesquelles on peut relier sélectivement par un commutateur (9) une borne (10) de la capacité (11) à mesurer.
